# EUROPEAN PATENT SPECIFICATION

(11) **EP 0 603 077 B1**
(45) Date of publication and mention of the grant of the patent: **26.08.1998**
(21) Application number: 93403059.4
(22) Date of filing: 16.12.1993
(51) Int. Cl.: H03K 5/15, H03K 4/00

(54) **Controlled delay digital clock signal generator**
Numerischer Taktgenerator mit gesteuerter Verzögerung
Générateur numérique de signaux à retard contrôlé

(30) Priority: 16.12.1992 FR 9215170
(43) Date of publication of application: 22.06.1994
(73) Proprietor: TEXAS INSTRUMENTS FRANCE, 06271 Villeneuve Loubet Cédex (FR); TEXAS INSTRUMENTS INCORPORATED, Dallas Texas 75265 (US)
(72) Inventor: Carbou, Pierre, F-06140 Vence (FR); Guignon, Pascal, F-83440 Callian Fayence (FR)
(74) Representative: Obolensky, Michel

(56) References cited:
- US-A- 4 119 916
- US-A- 4 137 503
- IEEE JOURNAL OF SOLID-STATE CIRCUITS., vol.SC-20, no.3, June 1985, NEW YORK US pages 770 - 774 R. WOUDSMA ET AL. 'The Modular Design of Clock-Generator Circuits in a CMOS Building-Block System'
- PATENT ABSTRACTS OF JAPAN vol. 12, no. 273 (E-639) 29 July 1988 & JP-A-63 054 012 (HITACHI, LTD.)

## Description

The present invention relates to controlled delay digital clock signal generators, also called analog phase shifters and more particularly to phase shifters for the production of delayed controlled digital clock signals.

One aim of the present invention is to produce a circuit able to generate several clock signals for a digital circuit from a single clock input signal.

Another aim is to generate clock signals with a predetermined phase relation and clock signals usable to obtain signals having values of multiples of two of the system clock input signal.

Its object is therefore a controlled delay digital clock signal generator, characterized in that it comprises the features recited in claim 1.

According to one characteristic of the invention, the means to generate the ramp signal comprise first, second, third and fourth current sources connected two by two in series between the supply voltage and eart with, interposed between the first and the third current sources and between the second and the fourth current sources connected in series, switches controlled respectively by generator output clock signals and connected by their terminals opposite the current sources to a condenser, the said first and second sources and the said third and fourth sources being controlled respectively by differential amplifier outputs, one input of which receives a reference voltage and the other input of which is connected to an error voltage integration condenser resulting from the difference between the charge time of another condenser connected firstly to the supply voltage via a switch activated by the generator output clock signal corresponding to a first segment of positive slope and a first segment of negative slope of the ramp signal, and secondly to earth via a switch activated by the generator clock output signal corresponding to a second segment of positive slope and a second segment of negative slope of the ramp signal, where the integration condenser is connected to the other condenser via a switch controlled by the said clock signal and its complementary signal.

According to other characteristics of the invention:
- the generator also comprises means of stabilisation of the delayed clock signal issued by the circuit for converting the ramp signal into a square signal, means of detection of the values of the high and low peaks of the ramp signal, means of comparison of the values of the high and low peaks with high and low reference voltages and for production of error signals for correction of the control of the current sources connected between the supply voltage and earth, respectively before and after the means of generating the ramp signal;
- means for achieving the logic combinations of square signals resulting from the conversion with the clock signals and the complementary clock signals which comprises two AND gates connected by one of their inputs to the output of the amplifier for conversion of the ramp signal into a square signal and by their other input to the clock signal and the complementary clock signal repectively, and two NOT-OR gates connected by one of their inputs to the output of the amplifier for converting the ramp signal into a square signal and by their other input to the complementary clock signal and the clock signal respectively.
- the means of detection of the peak values of the ramp signal comprise a peak detector produced from a switched capacity circuit and the reference voltage is created by a switched capacity generator;
- the condenser of the ramp signal generator is connected in parallel to the amplifier for conversion of the ramp signal into a square signal.

The invention will be better understood from the description which follows, given solely as an example and referring to the attached drawings on which:
- Figure 1 shows a circuit designed to generate a delayed clock signal from a reference clock signal;
- Figure 2 is a diagram as a function of time of the signals obtained by a first loop of the circuit in Figure 1;
- Figure 3 is a diagram as a function of time showing the three signals of Figure 2 and four clock signals dephased in relation to each other obtained by the circuit in Figure 1;
- Figure 4 shows the wave shape and the chronogram of evaluation of the error signal;
- Figure 5 shows the forms of the input and output clock wave with another ratio between the charge and discharge currents of a first condenser with a different charge and discharge current for a second condenser of the circuit in Figure 1;
- Figure 6 is a very detailed electrical diagram showing the use of the phase shift circuit of Figure 1;
- Figure 7 is an electrical diagram of a phase shift circuit according to the invention;
- Figure 8 shows a diagram as a function of time of the signals at various points of the circuit of Figure 7; and
- Figure 9 shows a practical design of the device according to the invention.

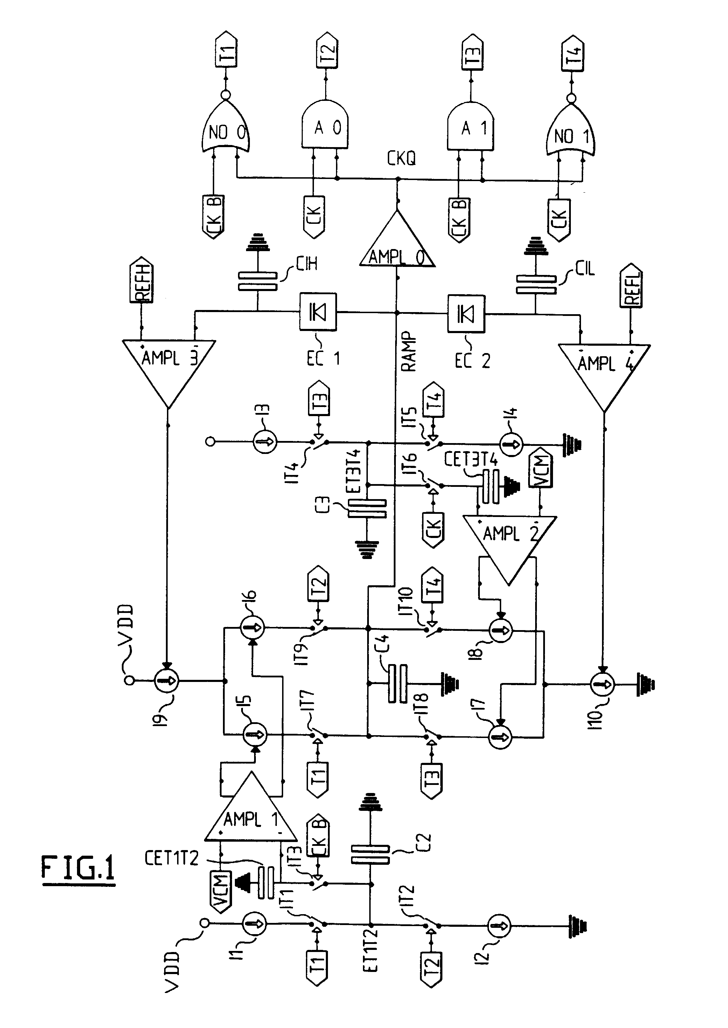

The aim of the circuit shown in Figure 1 is to generate a delayed signal from a reference clock signal. This circuit is intended to behave as a phase lock loop without voltage-controlled oscillator. The delay generated between the input and output signals is controlled by two loops.

The principle of the invention is to generate a triangular wave form, the amplitude of which is controlled by a first loop. This triangular wave form consists of four segments, two with positive slope and two with negative slope, the slope of each of these being controlled separately by a control loop. The delayed signal is generated by converting the triangular wave form into a square wave using a trigger circuit.

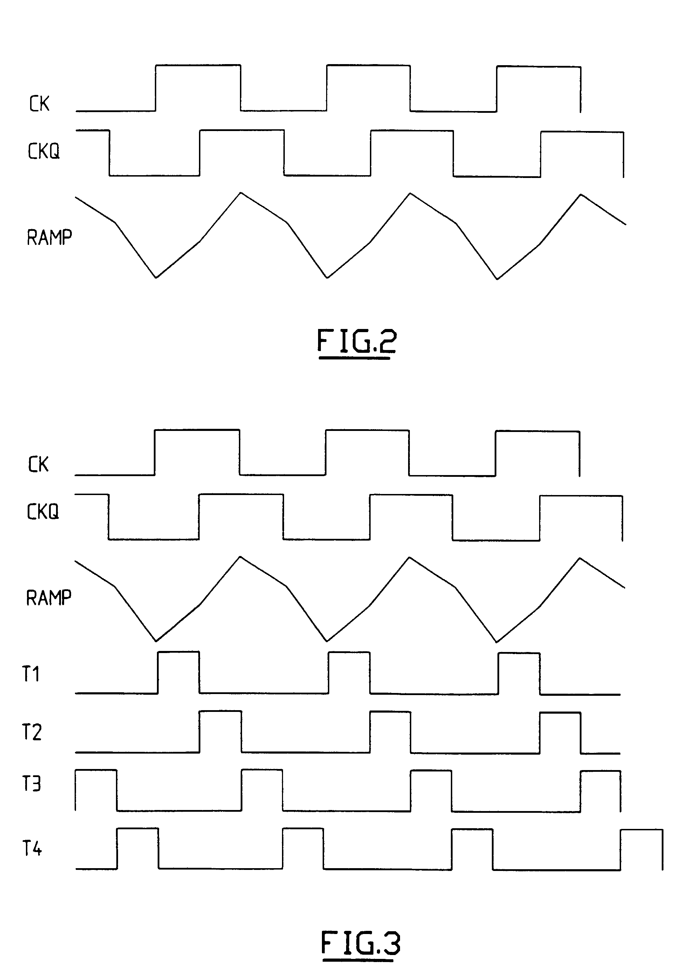

The shape of the input signal CK, the shape of the triangular ramp signal and the delayed output clock signal CKQ are shown in Figure 2.

The first design of the circuit according to the invention is shown in Figure 1.

This circuit comprises principally a first current source I1 connected in series with a second current source I2 between the supply voltage of the circuit and earth, and interposed therein two switches IT1, IT2 controlled by the circuit output signals T1 and T2 respectively.

At the junction point of switches IT1 and IT2 is connected an integration condenser CET1T2 via a switch IT3 controlled by signal CKB and also connected to earth.

Another condenser C2 links the junction point of switches IT1 and IT2 to earth.

Condenser CET1T2 is connected to the negative input of a differential amplifier AMPL1, the positive input of which is connected to a common mode signal VCM.

A circuit similar to that just described is achieved by means of a third and a fourth current source I3, I4, switches IT4, IT5, IT6, condensers CET3T4 and C3, and a differential amplifier AMPL2.

Switchs IT4 and IT5 are controlled by the output signals T3, T4 respectively, while switch IT6 is controlled by the clock signal CK.

The outputs of amplifiers AMPL1 and AMPL2 control current sources I5, I6 and I7, I8 respectively.

Sources I5 and I7 are connected in series and interposed therein switches IT7, IT8 controlled by circuit output signals T1 and T3.

Sources I5 and I8 are connected in series and interposed therein switches IT9, IT10 controlled by circuit output signals T2, T4 respectively.

Sources I5 and I6 are connected to the supply voltage VDD via a current source I9, whereas sources I7 and I8 are connected to earth via a current source I10.

The junction points of switches IT7, IT8 and IT9, IT10 are connected to a terminal of condenser C4, the other terminal of which is connected to earth.

The circuit just described constitutes a generator of a ramp signal with segments of different slopes. In the present example, the ramp signal has two segments of positive slope and two of negative slope (Figure 2).

Condenser C4 is also connected to the input of an amplifier AMPL0, the output of which gives a delayed clock signal CKQ.

Condenser C4 is also connected to a peak detector EC1, the output of which is linked to an input of a differential amplifier AMPL3. The other input of this amplifier receives a high reference signal REFH.

The output of amplifier AMPL3 controls current source I9.

A condenser CIH is connected between the peak detector EC1 and earth.

In the same way, condenser C4 is connected to a differential amplifier AMPL4 which controls current source I10 by means of a peak detector EC2 connected to an input of amplifier AMPL4, a condenser CIL being connected between the peak detector and earth, the other input of amplifier AMPL4 being connected to a low reference signal REFL.

The output of amplifier AMPL0 which gives output signals CKQ is connected to the first inputs of two NOT-OR gates, NO0 and NO1, and two AND gates A0 and A1.

The second input of the NOT-OR gate NO0 receives the clock signal CKB whereas the second input of the NOT-OR gate NO1 receives the clock signal CK.

The second inputs of the AND gates A0 and A1 receive signals CK and CKB respectively.

The outputs of gates NO0, A0, A1, NO1 produce respectively signals T1, T2, T3 and T4.

The triangular wave form known as RAMP is created by the four current sources I5, I6, I7 and I8 and condenser C4. Each current source is switched separately by signals T1, T2, T3 and T4 which represent the four logic combinations of the input clock signal CK and its complementary CKB with the delayed output signal CKQ.

Signal CK is obtained by transforming the RAMP signal into a square signal by means of amplifier AMPL0.

The logic combinations of signal CK and CKQ are produced by the logic gates NO0, A0, A1, NO1.

Signal CKB is obtained by logic inversion of clock signal CK. The NOT-OR function between the signals CKB and CKQ is provided by the gate NO0 to generate signal T1 shown in Figure 3.

Function AND between signals CK and CKQ is performed by the gate A0 to generate signal T2 in Figure 3, function AND between signals CKB and CKQ is performed by gate A1 to generate signal T3 and the NOT-OR function between signals CK and CKQ is performed by gate NO1 to generate signal T4 in Figure 3.

The slope of each segment forming the RAMP signal depends on the duration of signals T1, T2, T3 and T4 and on the value of the currents from sources I5 to I8 of the ramp signal generator.
Signals T1 and I5 define the first increasing segment;
Signals T2 and I6 define the second increasing segment;
Signals T3 and I7 define the first decreasing segment;
Signals T4 and I8 define the second decreasing segment.

Figure 3 shows the wave forms and the relations between the signals described above. When signal T1 is equal to signal T2 and signal T3 is equal to signal T4, the clock signals CK and CKQ are in quadrature.

By measuring the difference in duration between signals T1 and T2 and between signals T3 and T4, an error signal can be generated to control the value of current I5 in relation to I6 and that of current I7 in relation to I8 to reduce the duration errors to a minimum.

This error calculation betweeen signals T1 and T2 is carried out using current sources I1 and I2 switched respectively by signals T1 and T2 and switches IT1, IT2 and by condenser C2. During signal T1 causing the closure of switch IT1, condenser C2 is charged with a current I0 and during the presence of signal T2 causing the closure of switch IT2, the same condenser C2 is discharged with a current I0.

If T1 and T2 are of the same duration, the variation in charge of the condenser C2 is equal to 0 at the end of sequence T1, T2. Otherwise an error voltage appears at the terminals of condenser C2.

This error voltage known as ET1T2 is then integrated into condenser CET1T2 via a switch IT3 controlled by signal CKB. The integrated error signal controls the positive input of the amplifier AMPL1 with differential inputs and differential outputs. The outputs of this amplifier are used to control the relative value of current sources I5 and I6 in order to reduce the difference in duration between signals T1 and T2. The positive input of amplifier AMPL1 is connected to a common mode voltage VCM.

Similarly, the error calculation between signals T3 and T4 is carried out by sources I3 and I4 switched repsectively by signals T3 and T4 and the condenser CET3T4 and switch IT6 controlled by the clock input signal CK and connecting condenser C3 to amplifier AMPL2.

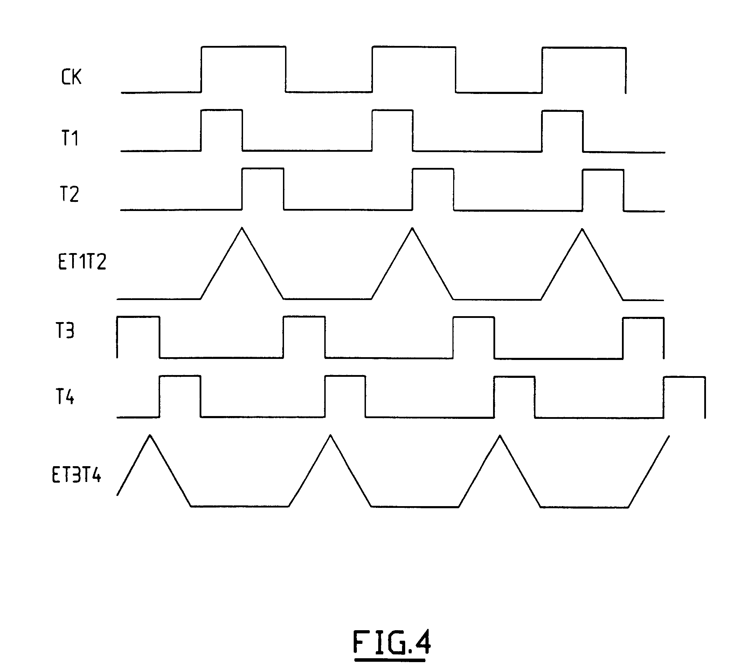

Figure 4 shows the wave form and chronogram of evaluation of the error signal.

In the description above, the error signal is equal to 0 when signal CK and CKQ are in quadrature. By selecting different values for the charge and discharge currents, the error calculation is degenerated and the resulting phase shift may differ from 90°. This property is useful for generating clock signals with any phase shift.

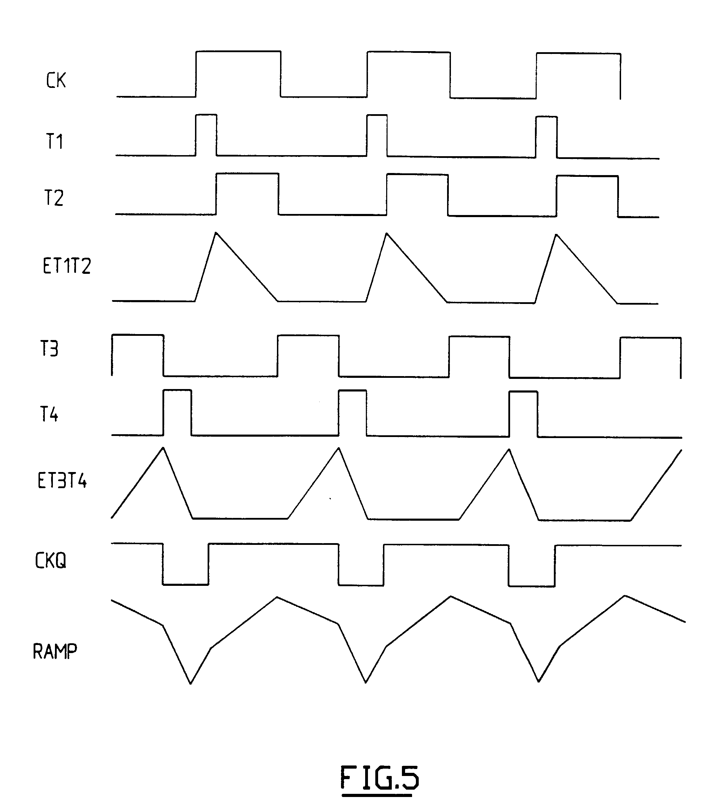

Figure 5 shows the forms of waves CK and CKQ with another ratio between the charge and discharge currents of condenser C2 and with different charge and discharge currents of condenser C3.

Because delayed signal CKQ is generated by transforming into a square signal the triangular RAMP wave form, the decision threshold is affected by noise and induces instability into the delayed clock signal.

In order to reduce this phenomenon to a minimum, the amplitude of the triangular RAMP signal wave form signal is optimised in relation to the supply voltage in order to obtain a maximum amplitude which allows an increase in the signal/noise ratio and hence a reduction in instability over a wide range of supply voltages.

The amplitude control circuit AMPL3, AMPL4 compares the high peak value of the ramp signal to a reference signal at REFH and the low peak value to a low level reference signal REFL.

The peak measurement circuit constituted by the detector EC1 stores the high peak value in the condenser CIH. The error amplifier AMPL3 measures the difference between the voltage at the terminals of condenser CIH and the reference voltage REFH, and uses this error signal to control the mean value of the charge current of condenser C4 by means of current source I9 (if there is no duration error I5 - I9 and I6 - I9, and if there is an error I5 - I9 +Ep, I6 - I9 -Ep). The same system is used to control the low peak value of the RAMP signal by means of a peak measurement circuit constituted by detector EC2, error amplifier AMPL4, a reference threshold REFL and current source I10, and mean values of I7 and I8. To optimise the amplitude of the triangular signal in relation to the supply voltage VDD, reference voltages are created from this supply voltage by a voltage division device which can be implemented by means of resistors or MOS devices the substrate of which is connected to the source.

The first design has the disadvantage of being dependent on the coefficient of voltage of the resistors available in CMOS technology.

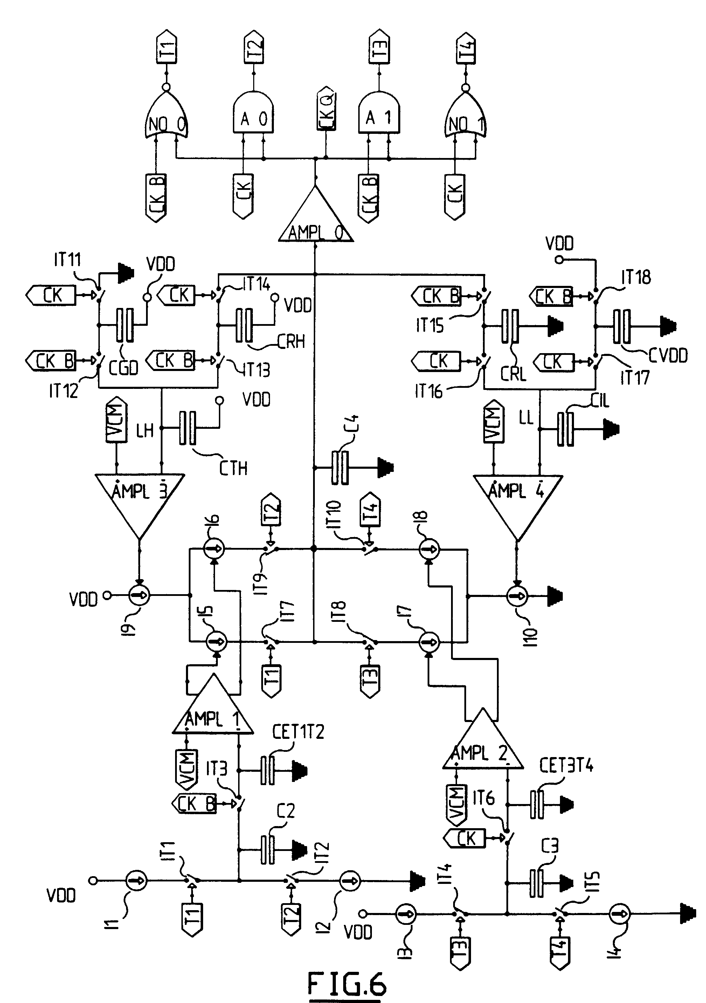

The second design is more accurate but does not allow a low supply voltage because of the threshold voltage of MOS devices. To avoid these disadvantages of the above designs, the peak detector and the reference voltage generator are produced using a circuit with switched capacity as shown in Figure 6, which otherwise represents a circuit similar to that in Figure 1.

The high peak detection circuit is formed by condenser CRH, switches IT11 to IT14 and amplifier AMPL3. Condenser CRH is connected between the RAMP signal and voltage VDD via switch T14 controlled by clock signal CK. The condenser CGD which forms part of the reference voltage generator is itself connected to earth via the switch IT11 and directly to voltage VDD. Throughout the duration of signals CKB, condensers CRH and CGD are both connected to condenser CIH through switches IT12 and IT13.

The result of this operation is compared with a common mode voltage VCM regulated at VDD/2 for example and the error voltage controls the value of the mean load cuurent I9 of condenser C4.

The same system is used to control the low peak amplitude of the ramp signal by means of condenser CRL and CVDD, and switches IT15, IT16 and IT17 and IT18 controlled by signals CKB, CK, CK and CKB respectively.

Amplifier AMPL4 performs the error calculation and control source I10 which supplies a current equal to the mean current of I7 and I8 which controls the negative slopes of the triangular ramp signal.

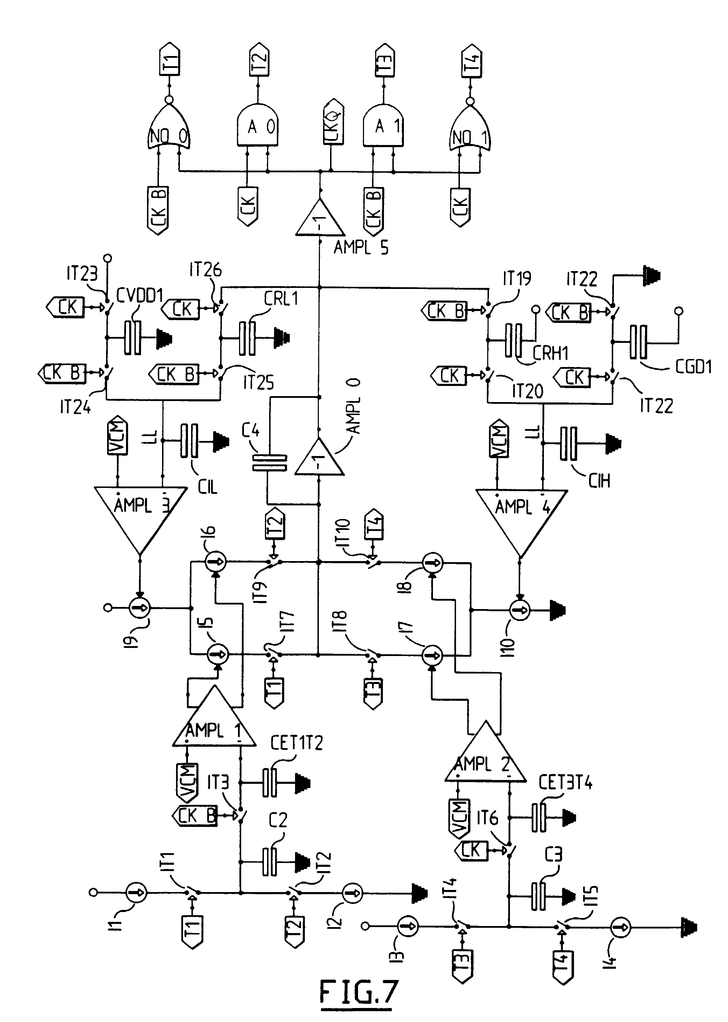

A second design of the invention will now be described with reference to Figure 7. With regard to the ramp signal generator, this is similar to the corresponding circuit in Figure 6 with the exception of the connection of condenser C4.

This structure improves the performance by reducing the sensitivity of the system to parasite elements. In this second design, condenser C4 is connected as a reaction condenser to amplifier AMPL0, the output of which is connected to the corresponding inputs of gates NO0, A0, A1, NO1 via a supplementary amplifier AMPLS. The peak detector circuits are connected between amplifiers AMPL0 and AMPL5. This enables the system to be independent of the voltage-sensitivity of current sources I5 to I8, as their common mode is no longer affected by voltage variations. This link becomes a virtual earth.

Another advantage lies in the fact that condensers CRH1 and CRL1 of the detector circuits are now connected to the output of amplifier AMPL0 and are no longer parasite elements for condenser C4.

This design implies the inversion of the RAMP signal in relation to that described in the first design.

Figure 7 shows in particular that the peak detection circuit comprises a condenser CVDD1 connected between the supply voltage VDD and earth via a switch IT23 controlled by clock signal CK. Condenser CVDD1 is also connected to a first input of an amplifier AMPL3, a second input of which receives the reference signal VCM. To the first input of amplifier AMPL3 is connected a condenser CIL, also connected to earth.

To the output of amplifier AMLP0 is connected a condenser CRL1 via a switch IT26. Another switch IT25 connects this condenser to the first input of amplifier AMPL3.

Switches IT23 and IT26 are controlled by signals CK where switches IT24 and IT25 are controlled by signals CKB.

A similar design achieved by means of condensers CRH1 and CGD1, switches IT19, IT20, IT21, IT22 controlled by signals CKB, CK, CK and CKB respectively, and an amplifier AMPL4, controls source I10.

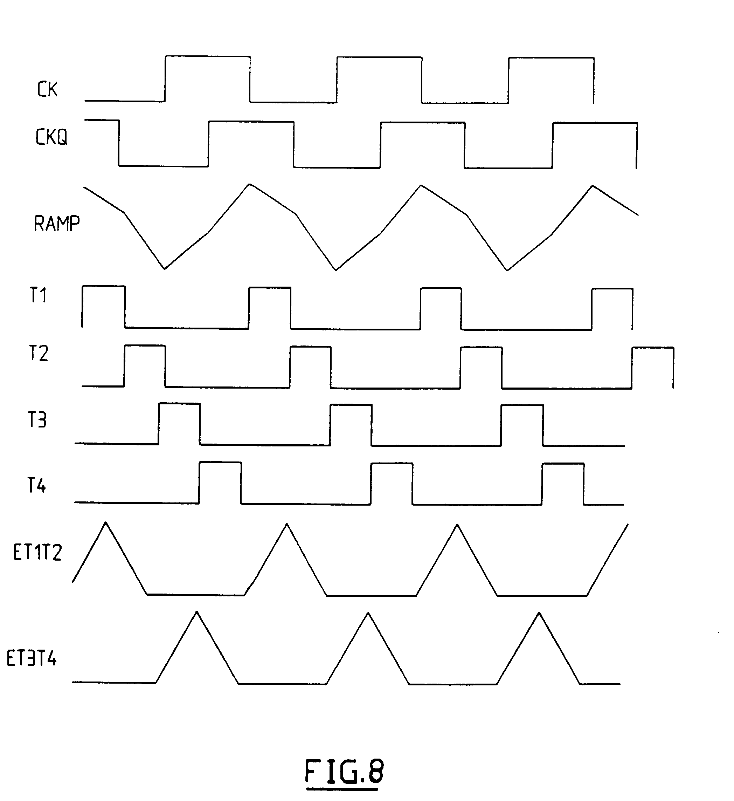

Thus several control signals must be inverted as shown on the diagram in Figure 8.

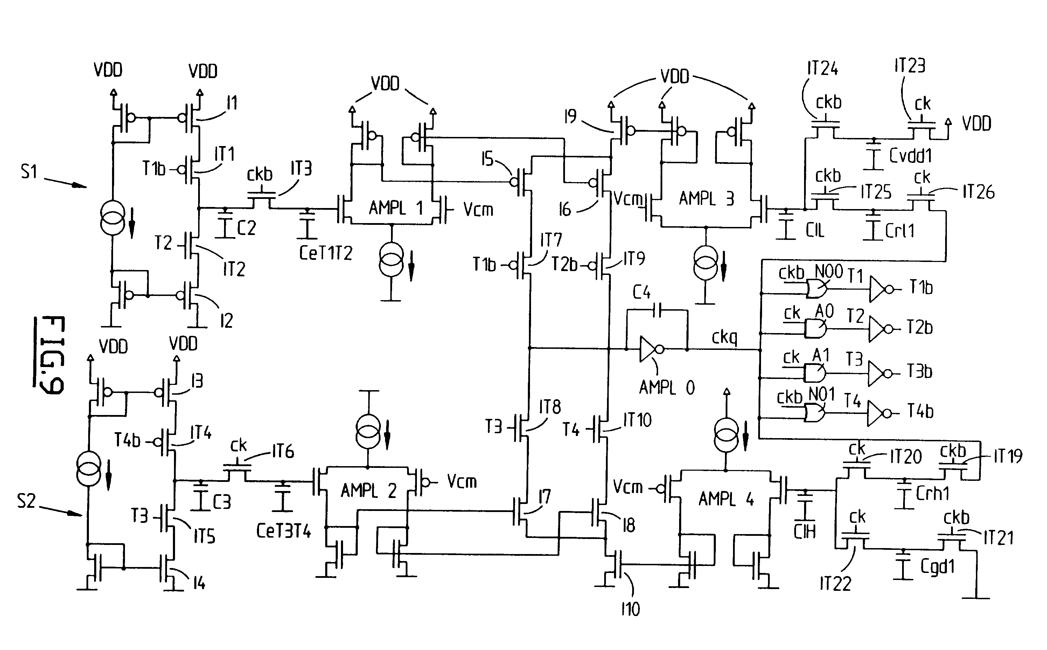

Figure 9 shows a possible design of the structure shown in Figure 7 using CMOS devices.

The components of this circuit which correspond to those of the circuit in Figure 7 bear the same reference numbers.

The circuit in Figure 9 differs from that in Figure 7 in that the CMOS transistors forming sources I1, I2 and I3, I4 are connected to stages of sources S1, S2 respectively.

Also to the outputs of gates NO0, A0, A1, NO1, are connected invertors INV1 to INV4 which invert the output signals T1 to T4 into signals T1B to T4B used to control the various components of the circuit.

The device which has just been described is particularly suitable for simple CMOS digital technology as it uses only components available in this type of technology.

The proposed structure used in standard digital CMOS technology allows the systematic creation of clock signals which have a well-defined phase shift. The cascading of several of these structures allows multiplication of the clock frequency and creates any phase relation between the phases of the said clock signals.

## Claims

1. Controlled delay digital clock signal generator for generating a delayed square clock signal (CKQ) from a clock signal (CK), characterized in that it comprises means (15,16,17,18,19, I10, IT7, IT8, IT9, IT10, C4) for generating from four output signals (T1,T2, T3, T4) a ramp signal (RAMP) comprising two segments of positive slope and two segments of negative slope, means (I1,I2,IT1,IT2,IT3, C2,CET1T2, AMPL1, I3, I4,IT4, IT5,IT6, C3, CET3T4, AMPL2) for separately controlling the slopes of the said segments, means of trigger circuits (AMPL0, AMPL5) for conversion of the ramp signal (RAMP) into the delayed square clock signal (CKQ), means (NO0, A0, A1, NO1) for achieving the four logic combinations of the delayed square clock signal (CKQ) with the clock signal (CK) and complementary clock signal (CKB) to obtain said four output signals.

2. Controlled delay digital clock signal generator according to claim 1, characterized in that the means for generating the ramp signal comprise first, second, third and fourth current sources (I5,I6,I7,I8) connected in series two by two between a supply voltage (VDD) and earth with interposed therein between the first and third current sources (I5,I7) and between the second and fourth current sources (I6,I8) respectively connected in series, switches (IT7,IT8,IT9,IT10) controlled respectively by the four output signals (T1,T3,T2,T4) of the generator and connected by their terminals opposite the current sources in common to a condenser (C4), wherein the said first and second sources (I5,I6) and the said third and fourth sources (I7,I8) are controlled respectively by the outputs of differential amplifiers (AMPL1, AMPL2) of which one input receives a reference voltage (VCM) and the other input is connected to a condenser (CET1T2, CET3T4) for integration of the error voltage (ET1T2, ET3T4) resulting from the difference between the charge of another condenser (C2, C3) through a current source (I1,I3) connected to the supply voltage (VDD) via a switch (IT1, IT4) activated by one of the four signals (T1, T3) of the generator corresponding to a first segment of positive slope and to the first segment of negative slope of the ramp signal (RAMP) and the discharge through a current source (I2,I4) to earth via a switch (IT2, IT5) activated by one of the four output signals (T2,T4) of the generator corresponding to a second positive slope segment of the ramp signal (RAMP) and to the second negative slope segment of the ramp signal (RAMP), wherein the integration condenser (CETIT2, CET3T4) is connected to the other condenser (C2, C3) by a switch controlled by the said clock signal and its complementary signal (CKB, CK).

3. Controlled delay digital clock signal generator according to one of claims 1 and 2, characterized in that it further comprises means for stabilisation of the delayed clock signal supplied by the circuit for converting the ramp signal into a square signal, comprising means (EC1, CIH, EC2, CIL) for detecting high and low peak values of the ramp signal (RAMP), means (AMPL3, AMPL4) for comparing the high and low peak values with high and low reference voltages (REFH, REFL) and for producing error signals for controlling correction current sources (I9, I10) connected between the supply voltage (VDD) and earth, respectively before and after the means for generating the ramp signal (RAMP).

4. Controlled delay digital clock signal generator according to one of claims 1 to 3, characterized in that the means for achieving the four logic combinations comprise two AND gates (A0, A1) connected by one of their inputs to the output of the amplifier (AMPL0) for converting the ramp signal (RAMP) into a square signal (CKQ) and by their other input to the clock signal (CK) and to the complementary clock signal (CKB) respectively and two NOT-OR gates (NO0, NO1) connected by one of their inputs to the output of the means of trigger circuits (AMPL0) and by their other input to the complementary clock signal (CKB) and to the clock signal (CK) respectively.

5. Controlled delay digital clock signal generator according to one of claims 3 and 4, characterized in that the means for detecting the peak values of the ramp signal (RAMP) comprise a peak detector consisting of a circuit with switched capacitors, and in that the reference voltage is generated by a generator with switched capacitors.

6. Controlled delay digital clock signal generator according to one of claims 2 to 5, characterized in that the condenser (C4) of the generator of the ramp signal is connected in counter-reaction to an amplifier (AMPL0) in the means of trigger circuits for conversion of the ramp signal (RAMP) into the delayed square signal (CKQ).

## Patentansprüche

1. Digitaler Taktsignalgenerator mit gesteuerter Verzögerung zum Erzeugen eines gegenüber einem Taktsignal (CK) verzögerten Rechteck-Taktsignals (CKQ)), dadurch gekennzeichnet, daß er enthält: eine Einrichtung (15, 16, 17, 18, 19, I10, IT7, IT8, IT9, IT10, C4), die aus vier Ausgangssignalen (T1, T2, T3, T4) ein Rampensignal (RAMP) erzeugt, das zwei Segmente mit positiver Steigung und zwei Segmente mit negativer Steigung enthält, eine Einrichtung (I1, I2, IT1, IT2, IT3, C2, CET1T2, AMPL1, I3, I4, IT4, IT5, IT6, C3, CET3T4, AMPL2) zum getrennten Steuern der Steigungen der Segmente, eine Einrichtung aus Triggerschaltungen (AMPL0, AMPLS) zum Umsetzen des Rampensignals (RAMP) in das verzögerte Rechteck-Taktsignal (CKQ) sowie eine Einrichtung (NO0, A0, A1, NO1) zur Erlangung der vier logischen Kombinationen des verzögerten Rechteck-Taktsignals (CKQ) mit dem Taktsignal (CK) und dem komplementären Taktsignal (CKB), um die vier Ausgangssignale zu erhalten.

2. Digitaler Taktsignalgenerator mit gesteuerter Verzögerung nach Anspruch 1, dadurch gekennzeichnet, daß die Einrichtung zum Erzeugen des Rampensignals eine erste, eine zweite, eine dritte und eine vierte Stromquelle (I5, I6, I7, I8) enthält, die paarweise zwischen eine Versorgungsspannung (VDD) und Erde in Serie geschaltet sind, wobei zwischen die erste und die dritte Stromquelle (I5, I7) und zwischen die zweite und die vierte Stromquelle (I6, I8) jeweilige Schalter (IT7, IT8, IT9, IT10) in Serie geschaltet sind, die durch die vier jeweiligen Ausgangssignale (T1, T3, T2, T4) des Generators gesteuert werden und mit ihren den Stromquellen gegenüberliegenden Anschlüssen gemeinsam an einen Kondensator (C4) angeschlossen sind, wobei die erste und die zweite Quelle (I5, I6) und die dritte und die vierte Quelle (I7, I8) jeweils durch die Ausgangssignale von Differenzverstärkern (AMPL1, AMPL2) gesteuert werden, wovon ein Eingang eine Referenzspannung (VCM) empfängt und der andere Eingang an einen Kondensator (CET1T2, CET3T4) angeschlossen ist, um die Fehlerspannung (ET1T2, ET3T4) zu integrieren, die sich ergibt aus der Differenz zwischen dem Laden eines weiteren Kondensators (C2, C3) durch eine mit der Versorgungsspannung (VDD) verbundene Stromquelle (I1, I3) über einen Schalter (IT1, IT4), der durch eines der vier Signale (T1, T3) des Generators aktiviert wird, das einem ersten Segment mit positiver Steigung und dem ersten Segment mit negativer Steigung des Rampensignal (RAMP) entspricht, und dem Entladen durch eine Stromquelle (I2, I4) zur Erde über einen Schalter (IT2, IT5), der durch eines der vier Ausgangssignale (T2, T4) des Generators aktiviert wird, das einem zweiten Segment mit positiver Steigung des Rampensignals (RAMP) und dem zweiten Segment mit negativer Steigung des Rampensignals (RAMP) entspricht, wobei der Integrationskondensator (CETIT2, CET3T4) mit dem anderen Kondensator (C2, C4) über einen durch das Taktsignal und dessen komplementäres Signal (CKB, CK) gesteuerten Schalter verbunden ist.

3. Digitaler Taktsignalgenerator nach einem der Ansprüche 1 und 2, dadurch gekennzeichnet, daß er eine Einrichtung zum Stabilisieren des von der Schaltung zum Umsetzen des Rampensignals in ein Rechtecksignal gelieferten verzögerten Datensignals enthält, die versehen ist mit einer Einrichtung (EC1, CIH, EC2, CIL) zum Erfassen hoher und niedriger Spitzenwerte des Rampensignals (RAMP) und einer Einrichtung (AMPL3, AMPL4) zum Vergleichen der hohen und niedrigen Spitzenwerte mit hohen und niedrigen Referenzspannungen (REFH, REFL) und zum Erzeugen von Fehlersignalen zum Steuern von Korrekturstromquellen (I9, I10), die vor bzw. hinter der Einrichtung zum Erzeugen des Rampensignals (RAMP) zwischen die Versorgungsspannung (VDD) und Erde geschaltet sind.

4. Digitaler Taktsignalgenerator mit gesteuerter Verzögerung nach einem der Ansprüche 1 bis 3, dadurch gekennzeichnet, daß die Einrichtung zum Erhalten der vier logischen Kombinationen zwei UND-Gatter (A0, A1), die mit einem ihrer Eingänge mit dem Ausgang des Verstärkers (AMPL0) zum Umsetzen des Rampensignals (RAMP) in ein Rechtecksignal (CKQ) und mit ihrem anderen Eingang mit dem Taktsignal (CK) bzw. mit dem komplementärem Taktsignal (CKB) verbunden sind, sowie zwei NICHT-ODER-Gatter (NO0, NO1) enthält, die mit einem ihrer Eingänge mit dem Ausgang der Einrichtung aus Triggerschaltungen (AMPL0) und mit ihrem anderen Eingang mit dem komplementären Taktsignal (CKB) bzw. mit dem Taktsignal (CK) verbunden sind.

5. Digitaler Taktsignalgenerator mit gesteuerter Verzögerung nach einem der Ansprüche 3 und 4, dadurch gekennzeichnet, daß die Einrichtung zum Erfassen der Spitzenwerte des Rampensignals (RAMP) einen Spitzendetektor enthält, der aus einer Schaltung mit geschalteten Kondensatoren besteht, und daß die Referenzspannung durch einen Generator mit geschalteten Kondensatoren erzeugt wird.

6. Digitaler Taktsignalgenerator mit gesteuerter Verzögerung nach einem der Ansprüche 2 bis 5, dadurch gekennzeichnet, daß der Kondensator (C4) des Rampensignal-Generators mit einem Verstärker (AMPL0) in der Einrichtung aus Triggerschaltungen in einer Gegenreaktionsanordnung verbunden ist, um das Rampensignal (RAMP) in das verzögerte Rechtecksignal (CKQ) umzusetzen.

## Revendications

1. Générateur numérique de signaux d'horloge à retard contrôlé, pour générer un signal d'horloge carré retardé (CKQ) à partir d'un signal d'horloge (CK), caractérisé en ce qu'il comporte des moyens (I5,I6,I7, I8,I9,I10,IT7,IT8,IT9,IT10,C4) pour générer à partir de quatre signaux de sortie (T1,T2,T3,T4), un signal de rampe (RAMP) comprenant deux segments de pente positive et deux segments de pente négative, des moyens (I1, I2, IT1, IT2, IT3, C2, CET1T2, AMPLI, I3, I4,IT4, IT5,IT6,C3, CET3T4, AMPL2) pour commander séparément les pentes desdits segments, des moyens à circuit de déclenchement (AMPL0, AMPL5) de conversion du signal de rampe (RAMP) en le signal carré d'horloge retardé (CKQ), des moyens (NOO, A0, A1, NO1) pour réaliser les quatre combinaisons logiques du signal carré d'horloge retardé (CKQ) avec le signal d'horloge (CK) et le signal d'horloge (CKB) complémentaire pour obtenir lesdits quatre signaux de sortie.

2. Générateur numérique de signaux d'horloge à retard contrôlé suivant la revendication 1, caractérisé en ce que les moyens pour générer le signal de rampe comprennent des première, seconde, troisième et quatrième sources de courant (I5,I6,I7,I8) connectées en série deux à deux entre une tension d'alimentation (VDD) et la masse avec interposition respectivement entre la première et la troisième sources de courant (I5,I7) et entre la seconde et la quatrième sources de courant (I6,I8) connectées en série, d'interrupteurs (IT7, IT8, IT9,IT10) commandés respectivement par les quatre signaux de sortie (T1, T3, T2, T4) du générateur et connectés par leurs bornes opposées aux sources de courant en commun à un condensateur (C4), lesdites première et seconde sources (I5, I6) et lesdites troisième et quatrième sources (I7,I8) étant respectivement commandées par les sorties d'amplificateurs différentiels (AMPL1, AMPL2) dont une entrée reçoit une tension de référence (VCM) et dont une autre entrée est connectée à un condensateur (CET1T2, CET3T4) d'intégration de la tension d'erreur (ET1T2, ET3T4) résultant de la différence entre la charge d'un autre condensateur (C2,C3) à travers une source de courant connecté à la tension d'alimentation (VDD) par l'intermédiaire d'un interrupteur (IT1, IT4) actionné par l'un des quatre signaux (T1,T3) du générateur correspondant à un premier segment de pente positive et à un premier segment de pente négative du signal de rampe (RAMP) et la décharge à travers une source de courant (I2,I4) à la masse, par l'intermédiaire d'un interrupteur (IT2, IT5) actionné par l'un des quatre signaux de sortie (T2,T4) du générateur correspondant à un second segment de pente positive du signal de rampe (RAMP), et au second segment de pente négative du signal de rampe (RAMP), le condensateur d'intégration (CET1T2, CET3T4) étant connecté à l'autre condensateur (C2,C3) par un interrupteur commandé par ledit signal d'horloge et son complémentaire (CKB,CK) .

3. Générateur numérique de signaux d'horloge à retard contrôlé suivant l'une des revendications 1 et 2, caractérisé en ce qu'il comporte en outre des moyens de stabilisation du signal d'horloge retardé délivré par le circuit de conversion du signal de rampe en signal carré, comprenant des moyens (EC1, CIH, EC2,CIL) pour détecter des valeurs de crêtes élevée et faible du signal de rampe (RAMP) des moyens (AMPL3, AMPL4) pour comparer les valeurs de crête élevée et faible à des tensions de référence élevée et faible (REFH, REFL) et pour produire des signaux d'erreur de commande de sources de courant de correction (I9, I10) connectées entre la tension d'alimentation (VDD) et la masse, respectivement en amont et en aval des moyens de génération du signal de rampe (RAMP).

4. Générateur numérique de signaux d'horloge à retard contrôlé suivant l'une des revendications 1 à 3, caractérisé en ce que les moyens pour réaliser quatre combinaisons logiques comprennent deux portes ET (A0, A1) connectées par une de leurs entrées à la sortie de l'amplificateur (AMPL0) de conversion du signal de rampe (RAMP) en signal carré (CKQ) et par leur autre entrée respectivement au signal d'horloge (CK) et au signal d'horloge complémentaire (CKB) respectivement et deux portes NON-OU (NO0, NO1) connectées par une de leurs entrées à la sortie des moyens à circuits (AMPL0) de déclenchement et par leur autre entrée respectivement au signal d'horloge complémentaire (CKB) et au signal d'horloge (CK).

5. Générateur numérique de signaux d'horloge à retard contrôlé suivant l'une des revendications 4 et 5, caractérisé en ce que les moyens de détection des valeurs de crêtes du signal de rampe (RAMP) comprennent un détecteur de crête réalisé à l'aide d'un circuit à capacités commutées et en ce que la tension de référence est engendrée par un générateur à capacités commutées.

6. Générateur numérique de signaux d'horloge à retard contrôlé, suivant l'une des revendications 1 à 5, caractérisé en ce que le condensateur (C4) du générateur de signal de rampe est connecté en contre-réaction sur un amplificateur (AMPL0), des moyens à circuits de déclenchement de conversion du signal de rampe (RAMP) en le signal carré retardé (CKQ).
